# EUROPEAN PATENT SPECIFICATION

(11) **EP 0 332 329 B1**
(45) Date of publication and mention of the grant of the patent: **12.05.1993**
(21) Application number: 89301982.8
(22) Date of filing: 28.02.1989
(51) Int. Cl.: H01L 21/20, H01L 29/205, H01L 29/267

(54) **Method for making a semiconductor substrate including a strained layer superlattice structure**
Verfahren zur Herstellung eines Halbleitersubstrats mit einer Schicht mit Uebergitterstruktur mit Spannungsschicht
Méthode pour fabriquer un substrat semi-conducteur comprenant une couche à structure de super réseau à couches de contrainte

(30) Priority: 01.03.1988 JP 45819/88
(43) Date of publication of application: 13.09.1989
(73) Proprietor: FUJITSU LIMITED, Kawasaki-shi, Kanagawa 211 (JP)
(72) Inventor: Okuda, Hiroshi, Atsugi-shi Kanagawa 243 (JP); Sugawara, Mitsuru, Atsugi-shi Kanagawa 243 (JP)
(74) Representative: Billington, Lawrence Emlyn

(56) References cited:
- EP-A- 0 166 593
- EP-A- 0 249 455
- APPL. PHYS. LETT. vol. 46, no. 7, April 1, 1985, pages 659-661, Am. Inst. of Physics.: New York, US; W.T. TSANG et al.: "GaSbO.5As0.5/A10.35Gao.65Sb065SbO.48Aao.52 superlattice lattice matched to InP prepared by molecular beam epitaxy
- JOURNAL OF APPLIED PHYSICS, vol. 59, no. 7, April 1986, pages 2447-2450, New York, US; M. QUILLEC et al.: "Growth and characterization of InxGa1-xAs/InyGa1-yAs strained-layer superlattice on InP substrate
- PATENT ABSTRACTS OF JAPAN, vol. 9, no. 332, (E-370)(2055) December 26, 1985; & JP-A-60 164 317
- PATENT ABSTRACTS OF JAPAN, vol. 12, no. 89, 17 E 592; & JP-A-62 222 626
- NINTH INTERNATIONAL SYMPOSIUM ON GALLIUM ARSENIDE AND RELATED COMPOUNDS, 1981, pages 137-142, Bristol, GB; A. USUI et al.: "Hybride VPE of InGaP and InGaAsP for visible application"
- MATERIALS RESEARCH SOCIETY SYMPOSIA PROCEEDINGS, vol. 31, Electron Microscopy of Materials, Boston, November 1983, pages 171-176, Elsevier Science Publishing Co., Inc. New York, US; O. UEDA et al.: "TEM observation of defects in InGaAsP and InGaP crystals on GaAs substrates grown by liquid phase epitaxy"
- JAPANESE JOURNAL OF APPLIED PHYSICS vol. 23, no. 8, August 1984, pages L623-L624, Part 2, Tokyo, JP; M. KAWABE et al.: "Disordering of Si-doped A1As/GaAs superlattice by annealing"
- ELECTRONICS LETTERS, vol. 20, no. 22, October 25, 1984, pages 916-918; T. SOGA et al.: "MOCVD growth of GaAs on Si substrates with A1GaP and strained superlattice layers"
- JAPANESE JOURNAL OF APPLIED PHYSICS, vol. 16, no. 10, 1977, pages 1875-1876 T. WAHO et al.: "GaAs1-x(0.3 x 0.9) grown by molecular beam epitaxy"
- APPLIED PHYSICS LETTERS, vol. 46, no. 3, February 1985, pages 294-296, American Institute of Physics, New York, US; M.A. TISCHLER et al.: "Defect reduction in GaAs epitaxial layers using a GaAsP-InGaAs layer superlattice"

## Description

The present invention relates to semiconductor substrates for the production of semiconductor transistor devices or photoelectronic devices, and more particularly to a method for making such a semiconductor substrate comprising a single-crystalline semiconductor wafer substrate, a compound-semiconductor epitaxial layer and a strained layer superlattice (SLS) structure layer between the wafer layer and the epitaxial layer.

An SLS structure layer is formed as a buffer layer between the semiconductor wafer substrate, such as a GaAs wafer or Si wafer, and a compound-semiconductor layer, such as an InGaP layer and GaAs layer, for the following reasons:
(1) the SLS buffer layer reduces dislocations in the grown compound-semiconductor layer by preventing the extension of threading dislocations from the substrate into the compound-semiconductor layer, due to the strain field in the SLS; and
(2) the SLS buffer layer allows epitaxial growth of the compound-semiconductor layer of a different lattice constant from that of the substrate by absorbing the lattice mismatch by virtue of the alternate expansion and contraction of the strained thin layers of the SLS structure layer.

This means that, instead of using a single-crystalline GaAs wafer substrate, a substrate of GaAs grown on Si (GaAs/Si) can be produced using the SLS structure layers, thus making possible a larger wafer size, increased mechanical strength and thermal conductivity, and reduced costs, compared with the GaAs wafer substrate. The lattice constant of GaAs is larger than that of Si by about 4% (e.g., cf. N.El-Masry et al, "Defect Reduction in GaAs Epilayers on Si Substrate Using strained Layer Superlattices", Mat. Res. Soc. Sympo. Proc. Vol. 91, 1987, pp. 99 - 103). Furthermore, it is often necessary to form (grow) a compound-semiconductor layer having a lattice constant different from or the same as that of the wafer substrate for light-emitting devices or lasers having a desired emission wavelength, while reducing the number of crystal defects such as dislocations. A discussion of an InGaAs SLS structure lattice matched to an InP substrate, so as to give rise to very few misfit dislocations, is given in the Journal of Applied Physics, Vol. 59 (1986) pp. 2447-2450.

Currently, there is a tendency to overestimate the effectiveness of the SLS buffer. In practice, although an SLS buffer uses a pair of compound-semiconductor layers having a large lattice mismatch therebetween, a compound-semiconductor epitaxial layer grown on the SLS buffer will have a high density of dislocations, five or six times larger than that of the wafer substrate, and when a graded layer is additionally grown between the wafer substrate and the SLS buffer, the compound-semiconductor epitaxial layer also has a high density of dislocations. Therefore, its effectiveness at reducing the number of dislocations in the SLS buffer is very low.

To obtain the required dislocation-reducing effect, the compound-semiconductor substrate including the SLS buffer should preferably be heat-treated at a high temperature so as to anneal out excessive dislocations.

A conventional SLS buffer, however, is not proof against a heat-treatment (annealing) at a high temperature, even for a short time, and a decay of the SLS structure by an interdiffusion of the alternating thin layers thereof occurs. Such diffusion is described, for instance, in the Japanese Journal of Applied Physics, Vol. 23 no. 8 (1984) pages L623-624 for an AlAs-GaAs superlattice. Therefore, although the number of dislocations is reduced, the decay of the SLS structure causes variations in the characteristics of the devices, for example an increase of a full-width at a half maximum (FWHM) of an LED, and prevents further annealing or thermal cycling improvement.

It is thus desirable to provide an improved strained layer superlattice (SLS) buffer layer which is not deformed (interdiffused) by a heat-treatment at a high temperature, including annealing for reducing the number of dislocations, heating for the epitaxial growth of an additional compound semiconductor layer, or annealing after ion-implantation; it is further desirable to improve the SLS structure layer between the wafer substrate and the epitaxial layer.

According to the present invention there is provided a method of making a semiconductor substrate as claimed in claim 1.

It is preferable that the temperature difference is 10°C or more.

The wafer substrate may be composed of a compound semiconductor (e.g., GaAs, InP, GaSb, GaP, InAs) or of silicon (Si).

Compound-semiconductor systems having a miscibility gap are described in Applied Physics Letters 46(7) (1985), pages 659-661, but no mention is made here of the relationship between the compositions used, nor of any annealing treatment.

The present invention will be more apparent from the description of the preferred embodiments set forth below, with reference to the accompanying drawings, in which:
Fig. 1 is a pseudo-binary phase diagram of an ABC (InₓGa₁₋ₓP) system of BC (GaP) - AC (InP);
Fig. 2 is a graph showing a relationship between a composition of the ABC (InGaP) and a chemical potential of A (In) at a temperature T₁;
Fig. 3A is a fragmented sectional view of a semiconductor substrate for explaining the present invention;
Fig. 3B is a graph of a lattice constant and a composition variation of the substrate of Fig. 3A;
Fig. 4A is a fragmented sectional view of another semiconductor substrate for explaining the present invention;
Fig. 4B is a graph of a lattice constant variation and composition variation of the substrate of Fig. 4A;
Fig. 5A is a fragmented sectional view of a GaAs/Si substrate for explaining the present invention; and
Fig. 5B is a graph of a lattice constant variation of the substrate of Fig. 5A.

According to the present invention, an SLS structure is thermally stabilized by utilizing a miscibility gap in a ternary or quaternary compound semiconductor system determining the alternating first and second compound semiconductor thin layers.

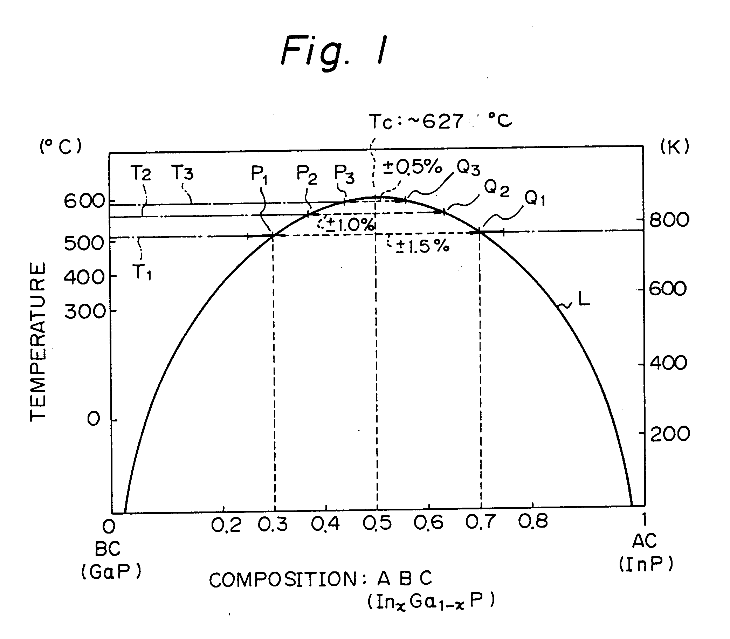

Figure 1 shows a pseudo-binary phase diagram of a ternary ABC (e.g., InₓGa₁₋ₓP) system at a combination of BC (III-V compound semiconductor, e.g., GaP) and AC (another III-V compound semiconductor, e.g., InP). The abscissa and ordinate of Fig. 1 indicate a ratio of "x" of component A (In) of the composition and temperature, respectively. In Fig. 1, points P₁ (P₂ , P₃) and Q₁ (Q₂ , Q₃) are limiting values of a complete solid solution state at a temperature T₁ (T₂ , T₃), between the points P₁ (P₂ , P₃) and Q₁ (Q₂ , Q₃) of a miscibility gap region. The continuous line L is a critical value, and the miscibility gap region is inside the line L. For example, in the InₓGa₁₋ₓP system points P₁ , P₂ , P₃ and Q₁ , Q₂ , Q₃ indicate the following compositions, at temperatures T₁ , T₂ and T₃ , and the degree of mismatch (strain value) given by the ratio of Δa to the lattice constant a of In_{0.5}Ga_{0.5}P:

| | |
|---|---|
| T₁ = 510°C: | P₁ = In_{0.3}Ga_{0.7}P |
| Δa/a = ±1.5%: | Q₁ = In_{0.7}Ga_{0.3}P |
| T₂ = 560°C: | P₂ = In_{0.37}Ga_{0.63}P |
| Δa/a = ±1.0%: | Q₂ = In_{0.63}Ga_{0.37}P |
| T₃ = 590°C: | P₃ = In_{0.43}Ga_{0.57}P |
| Δa/a = ±0.5%: | Q₃ = In_{0.57}Ga_{0.43}P |

The maximum temperature Tc of the miscibility gap is about 630°C.

A GaPSb system or an InGaAsP system can be adopted instead of the InGaP system.

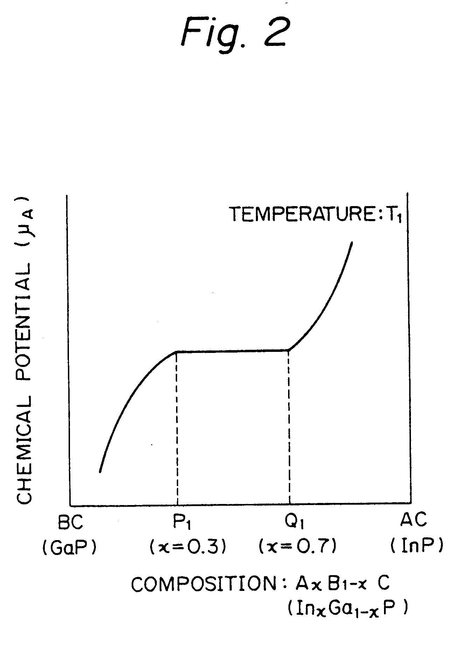

A chemical potential µA of component A (In) at a temperature T₁ varies as shown in Fig. 2. The abscissa and ordinate of Fig. 2 indicate the composition ABC (InₓGa₁₋ₓP) and the chemical potential, respectively.

The decay of the SLS structure due to a high temperature heat-treatment is caused by an interdiffusion of elements of each of the compound-semiconductor thin layers. When a gradient of the characteristic curve of the chemical potential exists, the gradient generates this interdiffusion, but between the points P₁ and Q₁ , the gradient is zero; in this region the following formula is valid and thus interdiffusion does not occur: 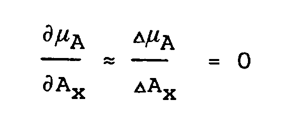
Therefore, if the SLS structure is formed on the one hand of compound-semiconductor thin layers having a composition at P₁ or in its vicinity which lies outside of the miscibility gap, and on the other hand and alternately of compound-semiconductor thin layers having another composition at Q₁ or in its vicinity which lies outside the miscibility gap, the SLS structure is extremely thermodynamically stable against a heat-treatment at a temperature T₁ , and thus the SLS structure does not decay. For example, for the SLS structure consisting of thin layers of In_{0.3}Ga_{0.7}P and In_{0.7}Ga_{0.3}P the limiting temperature is 510°C. If the temperature of the heat-treatment is 550°C, the SLS structure should be formed of In_{0.37}Ga_{0.63}P and In_{0.63}Ga_{0.37}P layers.

The GaAsSb system of GaAs-GaSb, or the InGaAs system of GaAs-InAs can be used for an SLS structure utilized in the growth of an epitaxial InP layer, since these systems have pseudo-binary phase diagrams similar to that of Fig. 1.

The GaAs₁₋ₓSbₓ system has the following data:

| | |
|---|---|
| T₁ ≈ 770°C: | P₁ = GaAs_{0.7}Sb_{0.3} |
| Δa/a = 1.5%: | Q₁ = GaAs_{0.3}Sb_{0.7} |
| T₂ ≈ 790°C: | P₂ = GaAs_{0.63}Sb_{0.37} |
| Δa/a = ±1.0%: | Q₂ = GaAs_{0.37}Ga_{0.63} |
| T₃ ≈ 820°C: | P₃ = GaAs_{0.566}Sb_{0.434} |
| Δa/a = 0.5%: | Q₃ = GaAs_{0.434}Sb_{0.566} |
| Tc ≈ 830°C | |

Here Δa/a indicates a degree of mismatch (strain value), Δa of GaAs₁₋ₓSbₓ being taken with reference to the lattice constant a of GaAs_{0.5}Sb_{0.5}.

The InₓGa₁₋ₓAs system has the following data:

| | |
|---|---|
| T₁ = 580°C | P₁ = In_{0.72}Ga_{0.28}As |
| Δa/a = ±1.5% | Q₁ = In_{0.28}Ga_{0.72}As |
| T₂ ≈ 600°C | P₂ = In_{0.65}Ga_{0.35}As |
| Δa/a = ±1.0% | Q₂ = In_{0.35}Ga_{0.65}As |
| T₃ ≈ 620°C | P₃ = In_{0.57}Ga_{0.43}As |
| Δa/a = ±0.5% | Q₃ = In_{0.43}Ga_{0.57}As |
| Tc ≈ 630°C | |

Again, Δa/a indicates a degree of mismatch, Δa of InₓGa₁₋ₓAs being referred to the lattice constant of In_{0.5}Ga_{0.5}As. In_{0.47}Ga_{0.53}As has the same lattice constant as that of InP.

Preferably the GaAsSb system is adopted, because the SLS structure of the GaAsSb system can withstand higher temperatures than the InGaAs system.

### Example 1

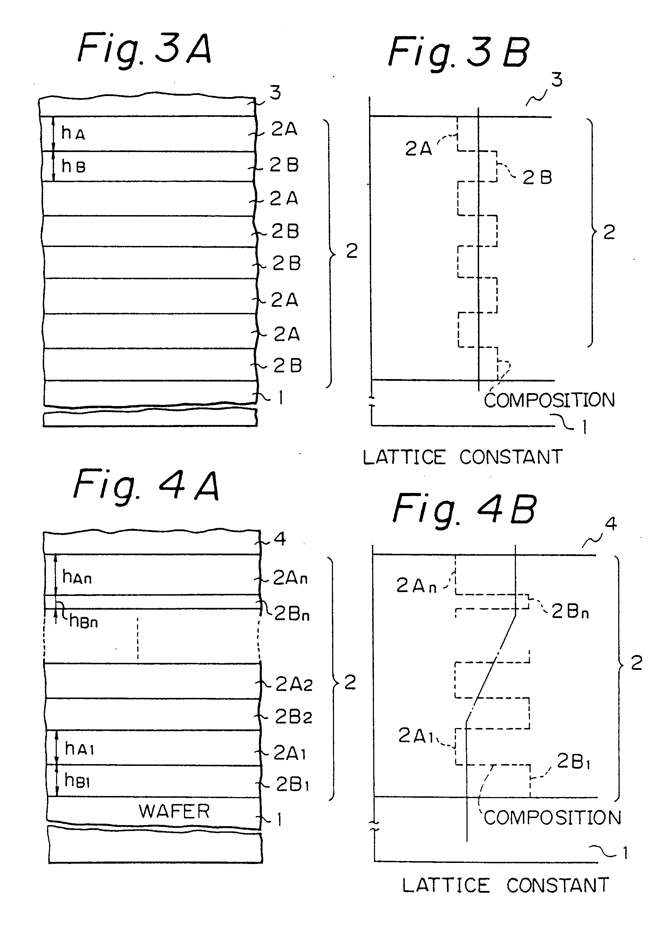

Referring to Figs. 3A and 3B, a semiconductor substrate illustrating the present invention consists of a single-crystalline GaAs wafer substrate 1, an SLS structure layer formed of In_{0.7}Ga_{0.3}P thin layers 2A having a constant thickness, and In_{0.3}Ga_{0.7}P thin layers 2B having a constant thickness, and an epitaxial In_{0.51}Ga_{0.49}P layer 3 having the same lattice constant as that of the GaAs wafer substrate 1.

In this case, the degree of mismatch (strain value), given by the ratio of Δa of the thin layers 2A and 2B to the lattice constant of In_{0.5}Ga_{0.5}P, is ±1.5%. Each of the thin layers 2A and 2B has a thickness of from 5 to 30 nm. Note, the thickness of the individual thin layers should be below the maximum critical thickness corresponding to the self-generation of misfit dislocations.

In the SLS structure the lattice constant "a₁₁" of an individual thin layer in a face parallel to the wafer substrate surface is determined by the following formula: 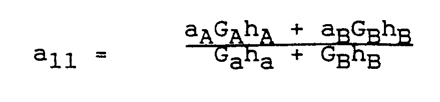
wherein:
a_{A} and a_{B} are unstrained lattice constants of the thin layers 2A and 2B, respectively;
h_{A} and h_{B} are thicknesses of the thin layers 2A and 2B, respectively; and
G_{A} and G_{B} are rigidities of the thin layers 2A and 2B, respectively.

This lattice constant "a₁₁" of the SLS structure can thus be made to coincide with that of the wafer ++substrate 1, as shown in Fig. 3B, by controlling the ratio ( ${\text{h}}_{\text{A}} {\text{/h}}_{\text{B}}$ ) of the thickness of the thin layer 2A to that of the thin layer 2B. For instance, the lattice constant "a₁₁" of the ten-period In_{0.3}Ga_{0.7}P (10.5 nm) - In_{0.7}Ga_{0.3}P (9.5 nm) SLS structure layer is equal to that of the GaAs wafer substrate, ${\text{h}}_{\text{A}} {\text{/h}}_{\text{B}}$ being about 21/19.

After the formation of the SLS structure layer 2, the In_{0.51}Ga_{0.49}P layer 3 is epitaxially grown under the condition that the lattice constant of the layer 3 is equal to that of the SLS structure layer 2, as shown in Fig. 3B.

Next, the obtained compound substrate is annealed, to reduce the number of dislocations, at a temperature of 500°C. The annealing reduces the number of dislocations, and thus stabilises the SLS structure without decay.

The AlGaInP lower clad layer, GaInP active layer, AlGaInP upper clad layer, and GaAs cap layer are then epitaxially and successively grown on the obtained compound-semiconductor substrate (i.e. the In_{0.51}Ga_{0.49}P layer 3) to produce an LED having an emission wavelength of about 650 nm.

### Example 2

Referring to Figs. 4A and 4B, another compound-semiconductor substrate illustrating the present invention consists of the GaAs wafer substrate 1, an SLS structure layer 2 formed of In_{0.3}Ga_{0.7}P thin layers 2A₁ , 2A₂ ... 2Aₙ and In_{0.7}Ga_{0.3}P thin layers 2B₁ , 2B₂ ... 2Bₙ , and an epitaxial In_{0.4}Ga_{0.6}P layer 4 having a smaller lattice constant than that of the GaAs wafer substrate 1.

To change the lattice constant "a₁₁" of the SLS structure layer from that of GaAs to that of In_{0.4}Ga_{0.6}P, as shown in Fig. 4B the ratio of the thickness h_{A1} (h_{A2} ... h_{An}) of the thin layer 2A₁ (... 2Aₙ) to that h_{B1} (h_{B2} ... Bₙ) of the thin layer 2B₁ (... 2Bₙ) of each pair of adjacent thin layers is gradually varied as follows:

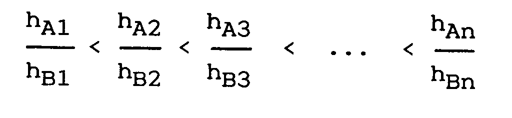

For example, a ten-period In_{0.3}Ga_{0.7}P (10.5 to 15 nm) - In_{0.7}Ga_{0.3}P (9.5 to 5 nm) SLS structure layer (in which ${\text{h}}_{\text{A1}} {\text{/h}}_{\text{B1}} \text{= 21/19}$ , ${\text{h}}_{\text{A10}} {\text{/h}}_{\text{B10}} \text{= 3/1}$ and one period thickness of 20 nm = constant) is suitable. The In_{0.4}Ga_{0.6}P layer 4 is epitaxially grown on the resulting SLS structure layer 2, the lattice constant of the layer 4 coinciding with the varied lattice constant "a₁₁" of the layer 2, as shown in Fig. 4B.

The obtained substrate is then annealed at 500°C to reduce the number of dislocations and stabilize the SLS structure without decay.

Instead of the above-mentioned thickness ratio variation InₓGa₁₋ₓP, wherein "x" starts at about 0.3 and is gradually reduced, can be used for the thin layers 2A₁ , 2A₂ ... 2Aₙ under the condition ${\text{h}}_{\text{A1}} {\text{/h}}_{\text{B1}} {\text{= h}}_{\text{A2}} {\text{/h}}_{\text{B2}} {\text{= ... = h}}_{\text{An}} {\text{/h}}_{\text{Bn}} \text{.}$ 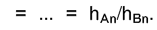 In this case, the value "x" is from 0.3 to the minimum critical value, beyond which misfit dislocations are generated.

### Example 3

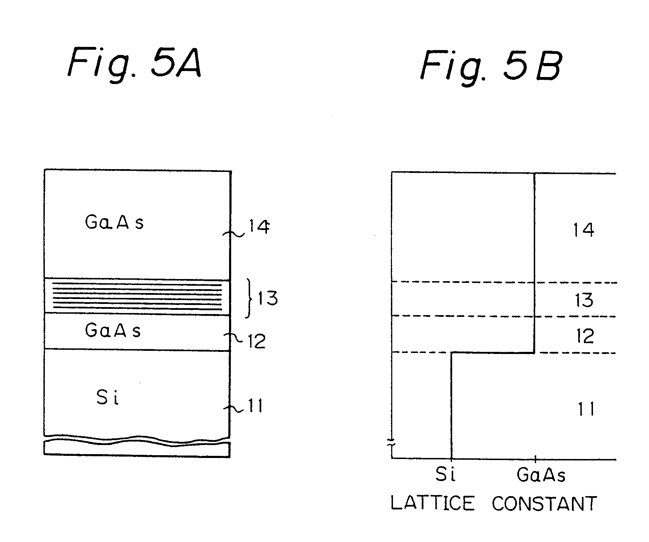

Referring to Figs. 5A and 5B, another semiconductor substrate illustrating the present invention is shown. This substrate consists of a single-crystalline silicon (Si) wafer substrate 11, a GaAs buffer layer 12, an SLS structure layer 13 of the ten-period In_{0.37}Ga_{0.63}P (9.2 nm) - In_{0.63}Ga_{0.37}P (10.8 nm), and a GaAs epitaxial layer 14.

The amorphous GaAs buffer layer 12 is deposited on the Si wafer substrate 11 by a conventional MOCVD process. A graded GaAs buffer layer could also be formed. Then, the SLS structure layer 13 consisting of In_{0.37}Ga_{0.63}P thin layers and In_{0.63}Ga_{0.63}P thin layers is formed on the GaAs buffer layer 12 by a MOCVD process to provide a lattice constant "a₁₁" equal to that of GaAs, as shown in Fig. 5B. Next, the GaAs epitaxial layer 14 is grown on the SLS structure layer 13 to obtain a GaAs/Si substrate.

The obtained semiconductor (GaAs/Si) substrate is annealed to reduce the number of dislocations without a decay of the SLS structure.

As described above, according to the present invention, each pair of compound-semiconductor thin layers of the SLS structure layer has compositions at both limit positions or the vicinity of the miscibility gap at a temperature corresponding to that of a heat-treatment, so that temperatures at or below that temperature do not affect the SLS structure. Therefore, suitable heat-treatments (annealing, etc.) can be applied to the obtained semiconductor substrate to reduce the number of dislocations, without decay of the SLS structure. The difference between the miscibility gap temperature and the heat-treatment temperature is preferably 10°C or more, since the compositions of the thin layers of the SLS structure layer may vary due to variation in the growth conditions.

## Claims

1. A method of making a semiconductor substrate comprising a single-crystalline semiconductor wafer substrate (1), a strained layer superlattice structure layer (2) formed on the said wafer substrate and a compound-semiconductor epitaxial layer (3) formed on the strained layer superlattice structure layer (2), the strained layer superlattice structure layer (2) comprising alternate thin layers (2A,2B) of a first compound semiconductor and a second compound semiconductor, wherein the first and second thin layers have the same components in a compound system having a miscibility gap but have different compositions lying outside the miscibility gap to each side respectively and on or in the vicinity of the limit line at a predetermined temperature, and the method includes the step of subjecting the substrate to a heat treatment at or below the said predetermined temperature.

2. A method according to claim 1, wherein the wafer substrate (1) is itself composed of a compound semiconductor.

3. A method according to claim 2, wherein the said compound-semiconductor material of the substrate consists of GaAs, InP, GaP, GaSb, or InAs.

4. A method according to claim 3, wherein the wafer substrate (1) is composed of GaAs, the epitaxial layer (3) is composed of InGaP, and the first and second thin layers (2A,2B) are composed of compounds in the GaP-InP system.

5. A method according to claim 1, wherein the wafer substrate (1) is composed of silicon.

6. A method according to claim 5, wherein the compound-semiconductor substrate further comprises a GaAs buffer layer (12) on the silicon wafer substrate (11), the epitaxial layer (14) is composed of GaAs, and the first and second thin layers (13) are composed of compounds from the InP-GaP system, the GaP-GaSb system or the GaP-InAs system.

7. A method according to claim 1, wherein the lattice constant of the epitaxial layer (3) is equal to that of the wafer substrate (1).

8. A method according to claim 7, wherein the ratio of the thicknesses of adjacent thin layers (2A,2B) of the first and second compound semiconductors is constant throughout the thickness of the superlattice.

9. A method according to any of claims 1 to 6, wherein the lattice constant of the epitaxial layer (3) is different from that of the wafer substrate (1).

10. A method according to claim 9, wherein the ratio of the thicknesses of adjacent thin layers (2An,2Bn) of the first and second compound semiconductors varies gradually with distance perpendicular to the substrate.

11. A method according to claim 9, wherein the ratio of the thicknesses of the adjacent thin layers is constant, and the composition of either the first or the second thin layers, or both, gradually varies.

12. A method according to any preceding claim, wherein the difference between the miscibility gap temperature and the heat-treatment temperature is 10°C or more.

## Patentansprüche

1. Verfahren zur Herstellung eines Halbleitersubstrats, das ein einkristallines Halbleiterscheibensubstrat (1), eine Spannschicht-Übergitterstrukturschicht (2), die auf dem genannten Scheibensubstrat gebildet ist, und eine epitaxiale Verbundhalbleiterschicht (3) umfaßt, die auf der Spannschicht-Übergitterstrukturschicht (2) gebildet ist, wobei die Spannschicht-Übergitterstrukturschicht (2) alternierende dünnen Schichten (2A, 2B) eines ersten Verbundhalbleiters und eines zweiten Verbundhalbleiters umfaßt, bei dem die ersten und zweiten dünnen Schichten die gleichen Komponenten in einem Verbundsystem mit einer Mischbarkeitslücke, jedoch unterschiedliche Zusammensetzungen aufweisen, die außerhalb der Mischbarkeitslücke an jeweils jeder Seite und an oder in der Nähe der Grenzlinie bei einer vorherbestimmten Temperatur liegen, und das Verfahren den Schritt des Aussetzens des Substrats einer Wärmebehandlung bei oder unter der genannten vorherbestimmten Temperatur beinhaltet.

2. Verfahren nach Anspruch 1, bei welchem das Scheibensubstrat (1) selbst aus einem Verbundhalbleiter besteht.

3. Verfahren nach Anspruch 2, bei welchem das genannte Verbundhalbleitermaterial des Substrats aus GaAs, InP, GaP, GaSb oder InAs besteht.

4. Verfahren nach Anspruch 3, bei welchem das Scheibensubstrat (1) aus GaAs besteht, die epitaxiale Schicht (3) aus InGaP besteht, und die ersten und zweiten dünnen Schichten (2A, 2B) aus Verbindungen im GaP-InP-System bestehen.

5. Verfahren nach Anspruch 1, bei welchem das Scheibensubstrat (1) aus Silizium besteht.

6. Verfahren nach Anspruch 5, bei welchem das Verbundhalbleitersubstrat ferner eine GaAs-Pufferschicht (12) auf dem Siliziumscheibensubstrat (11) umfaßt, die epitaxiale Schicht (14) aus GaAs besteht, und die ersten und zweiten dünnen Schichten (13) aus Verbindungen vom InP-GaP-System, dem GaP-GaSb-System oder dem GaP-InAs-System bestehen.

7. Verfahren nach Anspruch 1, bei welchem die Gitterkonstante der epitaxialen Schicht (3) gleich jener des Scheibensubstrats (1) ist.

8. Verfahren nach Anspruch 7, bei welchem das Verhältnis der Dicken benachbarter dünner Schichten (2A, 2B) der ersten und zweiten Verbundhalbleiter durch die gesamte Dicke des Übergitters konstant ist.

9. Verfahren nach einem der Ansprüche 1 bis 6, bei welchem die Gitterkonstante der epitaxialen Schicht (3) von jener des Scheibensubstrats (1) verschieden ist.

10. Verfahren nach Anspruch 9, bei welchem das Verhältnis der Dicken benachbarter dünner Schichten (2A, 2B) der ersten und zweiten Verbundhalbleiter mit dem Abstand senkrecht zum Substrat graduell variiert.

11. Verfahren nach Anspruch 9, bei welchem das Verhältnis der Dicken benachbarter dünner Schichten konstant ist, und die Zusammensetzung entweder der ersten oder der zweiten dünnen Schichten oder beider graduell variiert.

12. Verfahren nach einem der vorhergehenden Ansprüche, bei welchem die Differenz zwischen der Mischbarkeitslückentemperatur und der Wärmebehandlungstemperatur 10°C oder mehr beträgt.

## Revendications

1. Procédé de fabrication d'un substrat semiconducteur comprenant un substrat en forme de plaquette semiconductrice monocristalline (1), une couche de structure de super-réseau à couches sous contraintes (2) formée sur ledit substrat en forme de plaquette et une couche épitaxiale semiconductrice composite (3) formée sur la couche de structure de super-réseau à couches sous contraintes (2), la couche de structure de super-réseau à couches sous contraintes (2) comprenant des couches minces alternées (2A, 2B) en un premier semiconducteur composite et en un second semiconducteur composite, dans lequel les première et seconde couches minces comportent les mêmes composants selon un système composite qui présente une plage de miscibilité mais présentent des compositions différentes qui se s'étendent à l'extérieur de la plage de miscibilité sur chaque côté, respectivement sur la ligne limite et au voisinage de cette ligne limite pour une température prédéterminée, et le procédé incluant l'étape de soumission du substrat à un traitement thermique à ladite température prédéterminée ou au-dessous de cette dite température.

2. Procédé selon la revendication 1, dans lequel le substrat en forme de plaquette (1) est lui-même constitué par un semiconducteur composite.

3. Procédé selon la revendication 2, dans lequel ledit matériau semiconducteur composite du substrat est constitué par du GaAs, de l'InP, du GaP, du GaSb ou de l'InAs.

4. Procédé selon la revendication 3, dans lequel le substrat en forme de plaquette (1) est constitué par du GaAs, la couche épitaxiale (3) est constituée par de l'InGaP et les première et seconde couches minces (2A, 2B) sont constituées par des composés du système GaP-InP.

5. Procédé selon la revendication 1, dans lequel le substrat en forme de plaquette (1) est constitué par du silicium.

6. Procédé selon la revendication 5, dans lequel le substrat semiconducteur composite comprend en outre une couche tampon en GaAs (12) située sur le substrat en forme de plaquette en silicium (11), la couche épitaxiale (14) est constituée par du GaAs et les première et seconde couches minces (13) sont constituées par des composés dérivés du système InP-GaP, du système GaP-GaSb ou du système GaP-InAs.

7. Procédé selon la revendication 1, dans lequel la constante de réseau cristallin de la couche épitaxiale (3) est égale à celle du substrat en forme de plaquette (1).

8. Procédé selon la revendication 7, dans lequel le rapport des épaisseurs des couches minces adjacentes (2A, 2B) des premier et second semiconducteurs composites est constant sur toute l'épaisseur du super-réseau.

9. Procédé selon l'une quelconque des revendications 1 à 6, dans lequel la constante de réseau cristallin de la couche épitaxiale (3) est différente de celle du substrat en forme de plaquette (1).

10. Procédé selon la revendication 9, dans lequel le rapport des épaisseurs des couches minces adjacentes (2An, 2Bn) des premier et second semiconducteurs composites varie graduellement en fonction d'une distance mesurée perpendiculairement au substrat.

11. Procédé selon la revendication 9, dans lequel le rapport des épaisseurs des couches minces adjacentes est constant et la composition de soit la première couche mince, soit la seconde couche mince, soit les deux varie graduellement.

12. Procédé selon l'une quelconque des revendications précédentes, dans lequel la différence entre la température de la plage de miscibilité et la température de traitement thermique est de 10° C ou plus.
